# EUROPEAN PATENT APPLICATION

(11) **EP 2 866 536 A1**
(43) Date of publication of application: **29.04.2015**
(21) Application number: 13190339.5
(22) Date of filing: 25.10.2013
(51) Int. Cl.: H05K 5/00, H05K 7/14

(54) **Assembly and method for producing an assembly**

(71) Applicant: Harman Becker Automotive Systems GmbH, 76307 Karlsbad (DE)
(72) Inventor: Stachula, Peter, 75210 Keltern (DE)
(74) Representative: Westphal, Mussgnug & Partner Patentanwälte mbB

(57) **Abstract**

An assembly includes a chassis, at least one component mounted within the chassis and at least one compensation member. The compensation member includes a wall bounding a space; it also engages the component and is plastically deformable to provide dimensional tolerance compensation.

## Description

### TECHNICAL FIELD

The disclosure relates to an assembly such as a chassis or housing that encloses a plurality of stacked planar components (for example, circuit boards) and a method for producing an assembly.

### BACKGROUND

There are various situations in which it is desirable to accommodate a number of components within a single chassis or housing. For example, in situations in which it is desirable to enclose a plurality of stacked planar components such as circuit boards within a single housing, fixing means may be provided to retain the circuit boards in a stack within the housing such that adjacent circuit boards are spaced at a distance from each other. This may be desirable to eliminate unwanted electrical connections between adjacent circuit boards or to enable thermal cooling, for example, in the form of airflow over the surfaces of the circuit boards. Therefore, arrangements for such assemblies and methods for producing such assemblies are desirable.

### SUMMARY

An assembly includes a chassis, at least one component mounted within the chassis and at least one compensation member. The compensation member includes a wall bounding a space; it also engages the component and is plastically deformable to provide dimensional tolerance compensation.

A method for producing an assembly includes providing a chassis with two parts, providing at least one component and providing at least one compensation member (the compensation member comprising a wall bounding a space), arranging the at least one component on one part of the chassis, arranging the at least one compensation member in contact with the component, applying pressure to the at least one compensation member and plastically deforming the at least one compensation member to provide dimensional tolerance compensation.

Other systems, methods, features and advantages will be, or will become, apparent to one with skill in the art upon examination of the following figures and detailed description. It is intended that all such additional systems, methods, features and advantages be included within this description, be within the scope of the invention, and be protected by the following claims.

### BRIEF DESCRIPTION OF THE DRAWINGS

The system may be better understood with reference to the following drawings and description. The components in the figures are not necessarily to scale, emphasis instead being placed upon illustrating the principles of the invention. Moreover, in the figures, like referenced numerals designate corresponding parts throughout the different views.

Figure 1 is a diagram illustrating a first exemplary assembly.

Figure 2 is a diagram illustrating a second exemplary assembly.

Figure 3 is a diagram illustrating a third exemplary assembly.

### DETAILED DESCRIPTION OF THE PREFERRED EMBODIMENTS

In the following detailed description, reference is made to the accompanying drawings, which form a part hereof and which show by way of illustration specific embodiments in which the disclosure may be practiced. In this regard, directional terms such as top, bottom, front, back, leading, trailing, etc. are used with reference to the orientation of the figure(s) being described. Because components of embodiments can be positioned in a number of different orientations, the directional terminology is used for purposes of illustration and is in no way limiting. It is to be understood that the features of the various exemplary embodiments described herein may be combined with each other unless otherwise specifically noted.

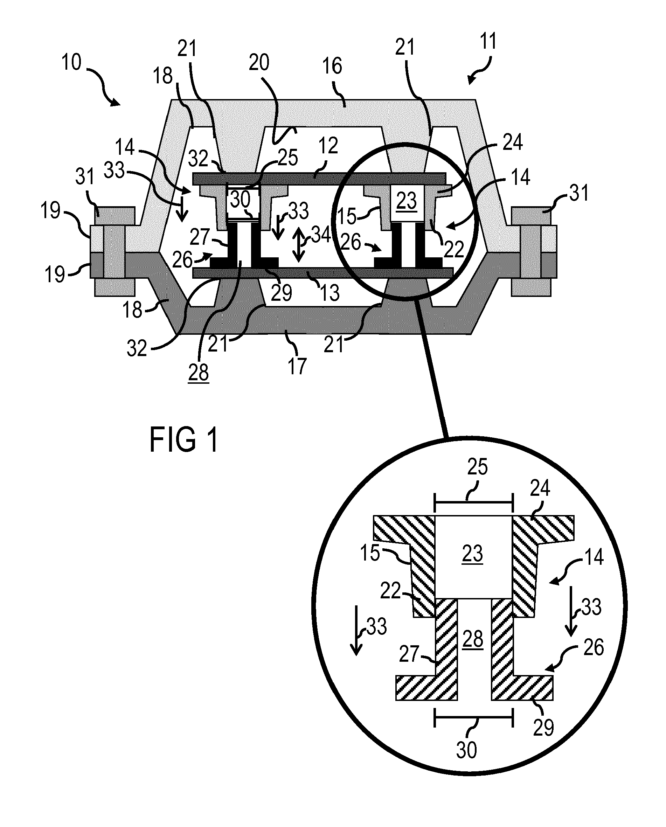

Figure 1 illustrates an exemplary assembly 10, including chassis 11, two components 12 and 13, which are to be mounted within chassis 11, and two compensation members 14. Chassis 11 includes upper part 16 and lower part 17, each having a recessed portion 18 surrounded by a flange 19, which protrudes outwardly from recessed portion 18. The two parts 16 and 17 are assembled together such that flanges 19 engage one another and recessed portions 18 form a cavity in which components 12 and 13 may be accommodated.

Components 12 and 13 are generally planar and are arranged in a stack, spaced apart from one another by compensation members 14. Components 12 and 13 may be electronic components such as circuit boards (for example, circuit boards of an amplifier).

Compensation members 14 comprise wall 22 bounding space 23. Compensation members 14 may each have a generally cylindrical hollow body 15 and may include flange 24 at one end, which protrudes outwardly and perpendicularly from wall 22. Flange 24 has inner diameter 25. Wall 22 tapers towards the opposing end of compensation member 14.

Each compensation member 14 comprises wall 27 bounding space 28 and is associated with a retaining member 26, which has a generally cylindrical form and flange 29 at one end. Outer diameter 30 of the retaining member is slightly greater than inner diameter 25 of compensation member 14 so that when the compensation member is aligned with retaining member 26, compensation member 14 can mechanically interlock with retaining member 26. Inner surface 20 of recessed portion 18 of upper part 16 and lower part 17 of chassis 11 comprises a plurality of protrusions 21, which are used to retain components 12 and 13.

Component 13 is arranged on protrusions 21 of lower part 17 of chassis 11, retaining members 26 are arranged on component 13, compensation members 14 on retaining members 26 and component 12 on compensation members 14 to produce a stack.

Compensation member 14 and retaining member 26 are positioned between the two components 12 and 13 such that flange 24 of compensation member 14 engages component 12, and flange 30 of retaining member 26 engages the second component 13. The cylindrical first compensation member 14 is aligned with and mechanically interlocks with retaining member 26 such that the inner surface of wall 22 of compensation member 14 engages the outer surface of wall 27 of retaining member 26.

The two parts 16 and 17 of chassis 11 may be secured to one another by fasteners 34 positioned in flange 19 surrounding the cavity. Fasteners 34 may be screws, bolts, etc. The protruding portions 21 of chassis 11 are aligned with compensation member 14 and retaining member 26 such that tip 32 of protrusion 21 is approximately coaxial with the inner diameter of compensation member 14 and retaining member 26.

Compensation members 14 have dimensions selected such that when pressure is applied to the two parts 16 and 17 of chassis 11, compensation member 14 and retaining member 26 are forced into an overlapping position so that at least compensation member 14 is plastically deformed to provide dimensional tolerance compensation, as indicated by arrows 33. This enables component 12 to be retained between respective protrusions 21 of upper part 16 of chassis 11 and compensation member 14 with its retaining member 26, and component 13 to be retained between respective protrusions 21 of part 17 of chassis 11 and compensation member 14 with its retaining member 26.

The dimensional tolerance compensation is provided by plastic deformation of compensation member 14 and, optionally, of retaining member 26. Fewer forces are distributed onto the two parts 16 and 17 of chassis 11 compared with an arrangement with spring members since compensation members 14 plastically deform rather than elastically deform to accommodate dimensional variations of components 12 and 13. Components 12 and 13 are retained securely within chassis 11, spaced at a distance from one another and parallel to one another. Compensation members 14 can compensate for variations in the thickness of the individual components 12 and 13 and variations in the thickness across one of components 12 or 13. Furthermore, the arrangement is simple to assemble since compensation members 14 provide both spacing and dimensional tolerance compensation functionality, reducing the number of pieces to be assembled.

A tapering form of protrusion 21 may be used to direct the forces from chassis 11 to compensation member 14 and retaining member 26 so as to ensure that plastic deformation of compensation member 14 and, optionally, of retaining member 26 accommodates variations in the dimensions of components 12 and 13 mounted within chassis 11.

In the exemplary assembly 10, the material of compensation members 14 is selected to have a thermal expansion coefficient that matches that of chassis 11 and/or components 12 and 13. For example, the thermal expansion coefficient of compensation member 14 may lie between the values of the thermal expansion coefficients of the chassis and of components 12 and 13. This may be used to provide thermal expansion tolerance compensation and dimensional tolerance compensation. This is schematically indicated in Figure 1 by arrow 34.

Two compensation members 14 are illustrated in Figure 1. However, the number and lateral arrangement of compensation members 14 may be varied depending on the lateral size of components 12 and 13 and of chassis 11.

Assembly 10 may be produced by providing chassis 11 with upper part 16 and lower part 17, providing at least one component 12 or 13 and providing at least one compensation member 14. Component 12 is arranged in lower part 17. Compensation members 14, with their respective retaining members 26, are arranged in contact with component 12, and component 13 is arranged on compensation members 14. Upper part 16 of chassis 11 is mounted onto lower part 17, which applies pressure to compensation members 14 and causes compensation member 14 to deform to provide dimensional tolerance compensation for chassis 11.

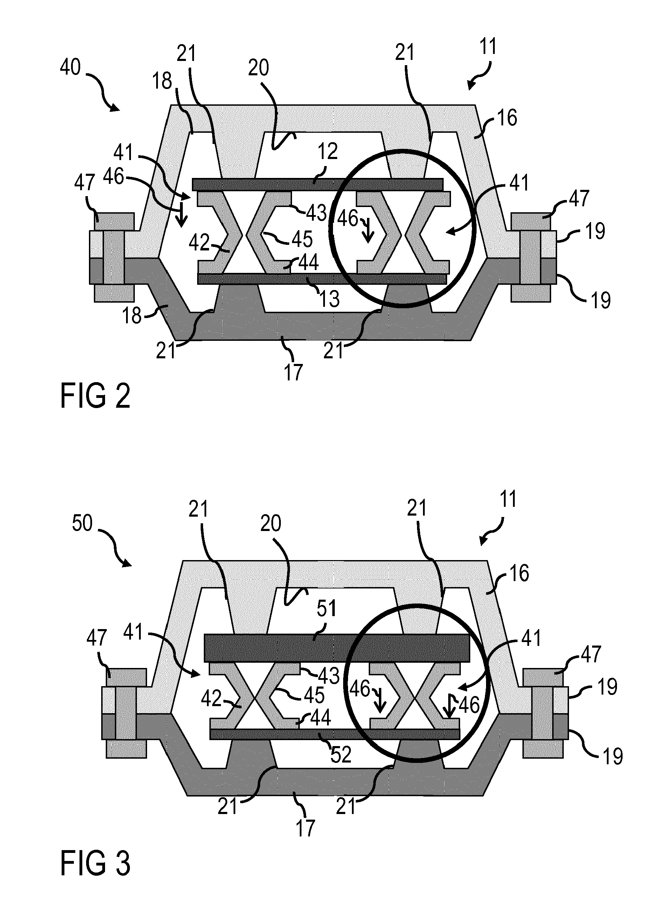

Figure 2 illustrates an exemplary assembly 40 including chassis 11 with upper part 16 and lower part 17; components 12 and 13 are mounted within chassis 11. The two components 12 and 13 are planar and may be circuit boards, as in the first exemplary assembly 10. The second exemplary assembly 40 differs from the first exemplary assembly 10 in the shape of compensation members 41.

In the exemplary assembly 40, compensation members 41 each have a generally cylindrical hollow body 42 with flanges 43 and 44 at each opposing end protruding from the body, and they further include a narrowed waist portion 45 positioned generally in the center of cylindrical hollow body 42. Compensation members 41 can be considered to have a generally X-shaped longitudinal cross-section.

Compensation members 41 are positioned between the two components 12 and 13 such that flange 43 engages the surface of component 12 and flange 44 engages the surface of component 13 in order to space the two components 12 and 13 at a distance from one another. Compensation members 41 are laterally positioned so that protrusions 21 of chassis 11 are approximately coaxial with the inner diameter of compensation member 41 at flanges 43 and 44. As the two parts 16 and 17 of chassis 11 are brought together such that flanges 19 of the two parts 16 and 17 engage one another, compensation members 41 are plastically deformed, as is indicated by arrows 46, such that the distance between the two components 12 and 13 is slightly reduced and the inner diameter of waist portion 45 is slightly decreased.

After chassis 11 has been assembled by tightening fastening means 47, components 12 and 13 are retained between protruding portions 21 of the two parts 16 and 17 of chassis 11 and compensation members 41.

As in the exemplary assembly 10, the material of compensation members 41 may be selected to have a thermal expansion coefficient with a value between the value of the thermal expansion coefficient of the material of chassis 11 and that of components 12 and 13 in order to provide thermal expansion tolerance compensation.

Compensation members 41 may have outer dimensions and a wall thickness and may be selected from a material to enable plastic deformation of compensation members 41 upon application of pressure to the compensation member by the two parts 16 and 17 of chassis 11. In particular, the outer dimensions and the wall thickness may be selected to provide a particular dimensional tolerance compensation range.

Figure 3 illustrates an exemplary assembly 50 including chassis 11, compensation members 41 and components 51 and 52. Chassis 11 and compensation members 41 are similar to those of the exemplary assembly 40. In the exemplary assembly 50, upper planar component 51 of the stack has a greater thickness than upper component 12 of the exemplary assembly 40. Components 51 and 52 may be circuit boards and assembly 50 may be an amplifier assembly, as in the exemplary assembly 40.

Upon assembly of the two parts 16 and 17 of chassis 11 such that flanges 19 of parts 16 and 17 engage one another, compensation members 41 are plastically deformed to a greater degree in order to provide dimensional tolerance compensation for upper component 51, which has a greater thickness. This is schematically demonstrated in Figure 3 by touching inner surface 53 of waist portion 45 of compensation members 41. As in the first and second exemplary assemblies, the third exemplary assembly 50 provides dimensional tolerance compensation by plastic deformation of compensation members 41 and provides thermal tolerance compensation by appropriate selection of the thermal expansion coefficient of the material of compensation members 41.

The exemplary assemblies illustrated in the drawings include two components and two compensation members. However, the assembly is not limited to this arrangement and may also include one or three or more components and one or three or more compensation members. In the case of a stack of three or more generally planar components, one or more compensation members may be positioned between each adjacent component in the stack.

The expansion compensation members may also be positioned between a component and the chassis rather than directly between two components. This arrangement may be useful in the case of one component such that the component is retained between the chassis on a first side and a compensation member on the opposing side, which makes direct contact with the opposing portion of the chassis.

In another exemplary assembly, the assembly may comprise a plurality of circuit boards that are arranged in a stack including compensation members positioned between adjacent circuit boards of the stack. The chassis may provide an enclosed housing including one or more through-holes or ports for enabling the printed circuit boards within the chassis to be electrically connected to further components outside the chassis. The assembly may encase an amplifier circuit.

While various embodiments of the invention have been described, it will be apparent to those of ordinary skill in the art that many more embodiments and implementations are possible within the scope of the invention. Accordingly, the invention is not to be restricted except in light of the attached claims and their equivalents.

## Claims

1. An assembly comprising a chassis, at least one component mounted within the chassis and at least one compensation member, wherein the compensation member comprises a wall bounding a space, engages the component and is plastically deformable to provide dimensional tolerance compensation.

2. The assembly of claim 1, wherein:
the compensation member is cylindrical, or
the compensation member is generally cylindrical and comprises a narrowed waist, or
the compensation member is generally cylindrical and tapers towards one end, or
the compensation member comprises a generally X-shaped longitudinal cross-section.

3. The assembly of claim 1 or claim 2, further comprising a retaining member, wherein the second retaining member comprises a wall bounding a space and the compensation member mechanically interlocks with the retaining member and is plastically deformed.

4. The assembly of any of claims 1 to 3, wherein the compensation member further engages the chassis or another component mounted within the chassis.

5. The assembly of any of claims 1 to 4, wherein the compensation member further comprises at least one flange that engages at least one of the components, the chassis and another component mounted within the chassis.

6. The assembly of any of claims 1 to 5, wherein the chassis further comprises at least one protruding portion aligned with the compensation member, the component is retained between the protruding portion and the compensation member and the compensation member is plastically deformed.

7. The assembly of claim 6, wherein the protruding portion tapers to an area less than the inner diameter of the compensation element.

8. The assembly of any of claims 1 to 7, wherein the chassis comprises at least two parts enclosing the at least one component, the two parts being dimensioned so that they cause plastic deformation of the compensation member when attached to each other.

9. The assembly of any of claims 1 to 8, wherein the component has a generally planar portion.

10. The assembly of any of claims 1 to 9, wherein the assembly comprises at least two components arranged in a stack, each component comprising a circuit board.

11. The assembly of claim 10, wherein adjacent circuit boards are spaced apart by at least one compensation member positioned between the two circuit boards.

12. The assembly of any of claims 1 to 11, wherein the compensation member comprises a thermal expansion coefficient matched to that of the component and that of the chassis over a predetermined temperature range to provide thermal expansion tolerance.

13. A method for producing an assembly that meets the following requirements:
provides a chassis comprising two parts;
provides at least one component and at least one compensation member, the compensation member comprising a wall bounding a space;
arranges the at least one component on one part of the chassis;
arranges the at least one compensation member in contact with the component;
applies pressure to and plastically deforms the at least one compensation member to provide dimensional tolerance compensation.

14. The method of claim 13, wherein the pressure is applied to the at least one compensation member by attaching the two parts of the chassis to each other.

15. The method of claim 13 or 14, wherein at least one compensation member is arranged between the chassis and the component and/or between two components.
